(19) Europäisches Patentamt
European Patent Office
Office européen des brevets

(11) **EP 3 624 334 A1**

(12) **EUROPÄISCHE PATENTANMELDUNG**

(43) Veröffentlichungstag:
**18.03.2020 Patentblatt 2020/12**

(51) Int Cl.:
**H03C 3/40** *(2006.01)* **H03M 1/64** *(2006.01)*

(21) Anmeldenummer: **18194798.7**

(22) Anmeldetag: **17.09.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft 80333 München (DE)**

(72) Erfinder: **Prochaska, Dirk 09127 Chemnitz (DE)**

(54) **VORRICHTUNG ZUR WANDLUNG EINES ANALOGEN EINGANGSSIGNALS IN EIN DIGITALES AUSGANGSSIGNAL**

(57)     Die Erfindung beschreibt eine Vorrichtung zur Wandlung eines analogen Eingangssignals (Sig$_A$) in ein digitales Ausgangssignal (Sig$_D$) . Die erfindungsgemäße Vorrichtung umfasst einen Amplitudenmodulator (10) mit Trägerunterdrückung zur Bereitstellung eines trägerlosen AM-Signals, dem das analoge Eingangssignal an einem Signaleingang (11) zugeführt wird. Ferner weist sie einen Addierer (20) auf, dem das von dem Amplitudenmodulator (10) ausgegebene trägerlose AM-Signal zugeführt wird und der dazu eingerichtet ist, zu dem AM-Signal ein um 90° verschobenes Trägersignal zu addieren und ein phasenmoduliertes Signal (PM-Signal) auszugeben. Die erfindungsgemäße Vorrichtung umfasst schließlich einen Begrenzer (30), dem das von dem Addierer (20) ausgegebene PM-Signal zugeführt wird und der dazu ausgebildet ist, eine störende Amplitudenmodulation in dem PM-Signal zu unterdrücken. Die Gesamtanordnung ist vorwiegend in digitaler Schaltungstechnik aufgebaut und ist daher gut integrierbar. Ein weiterer Vorteil ist die enthaltene Möglichkeit der einfachen Potenzialtrennung.

## FIG 1

EP 3 624 334 A1

**Beschreibung**

Die Erfindung betrifft eine Vorrichtung zur Wandlung eines analogen Eingangssignals in ein digitales Ausgangssignal. Eine solche Vorrichtung wird auch als Analog-Digital-Wandler bezeichnet.

Ein Analog-Digital-Wandler dient dazu, eine analoge Eingangsgröße in ein digitales Signal zu konvertieren. Bekannte Analog-Digital-Wandler sind z.B. der SAR-Wandler (Sukzessiv-Approximations-Wandler) und der Sigma-Delta-Wandler. Beide Wandlertypen sind mit Nachteilen verbunden, welche aus Gleichspannungsfehlern des analogen Eingangssignals resultieren. Beim Sigma-Delta-Wandler wird ein Vergleichssignal gebildet, welches analog gefiltert, d. h. rekonstruiert, wird. Sprünge des analogen Eingangssignals können daher zu Einschwingfehlern führen. Um galvanisch getrennte Eingänge zu realisieren, sind für jeden Eingangskanal vollständig getrennte A/D-Wandler erforderlich. Der SAR-Wandler weist das Problem auf, dass ein signifikantes Quantisierungsrauschen auftritt. Ferner ist für die Skalierung eine sehr genaue Amplitudenreferenz erforderlich, welche temperatur- und altersstabil ist. Eine obere Grenzfrequenz der in dem A/D-Wandler eingesetzten Komponenten beschränkt die Nutzbarkeit bei höheren Signalfrequenzen.

Um die oben genannten Probleme zu beseitigen, werden sog. Chopper-Verstärker eingesetzt. Eine galvanische Trennung wird durch getrennte Wandler mit eigenem Potential realisiert. Eine Verschiebung der oberen Grenzfrequenz ist hingegen derzeit nicht möglich. Auch genaue, stabile Referenzen zur Skalierung sind aufwändig und teuer.

Es ist Aufgabe der Erfindung, eine Vorrichtung zur Wandlung eines analogen Eingangssignals in ein digitales Ausgangssignal anzugeben, welche baulich und/oder funktional verbessert ist.

Diese Aufgabe wird gelöst durch eine Vorrichtung gemäß den Merkmalen des Patentanspruches 1. Vorteilhafte Ausgestaltungen ergeben sich aus den abhängigen Patentansprüchen.

Es wird eine Vorrichtung zur Wandlung eines analogen Eingangssignals in ein digitales Ausgangssignal vorgeschlagen. Die Vorrichtung, nachfolgend auch als A/D-Wandler bezeichnet, umfasst einen Amplitudenmodulator mit Trägerunterdrückung zur Bereitstellung eines trägerlosen amplitudenmodulierten Signals (AM-Signal), einen Addierer und einen Begrenzer. Dem Amplitudenmodulator mit Trägerunterdrückung wird das analoge Eingangssignal an einem Signaleingang zugeführt. Dem Addierer wird das von dem Amplitudenmodulator ausgegebene trägerlose AM-Signal zugeführt. Der Addierer ist dazu eingerichtet, zu dem AM-Signal ein um 90° verschobenes Trägersignal zu addieren und ein phasenmoduliertes Signal (PM-Signal) bereitzustellen. Schließlich wird dem Begrenzer das von dem Addierer ausgegebene PM-Signal zugeführt. Der Begrenzer ist dazu ausgebildet, eine störende Amplitudenmodulation in dem PM-Signal zu unterdrücken.

Die erfindungsgemäße Vorrichtung nutzt somit eine Phasenmodulationswandlung. Durch die Phasenmodulation eines analogen Signals, welches auf einer Amplitudenmodulation basiert, und der Begrenzung des phasenmodulierten Signals entsteht ein Signal mit einer Amplitude, welches lediglich aus 0 oder 1 besteht. Die Länge dieser Impulse ist wertkontinuierlich, in Abhängigkeit einer Trägerfrequenz.

Dieses Vorgehen weist eine Reihe von Vorteilen auf. Beispielsweise können Offset-Fehler in der Signalverarbeitungskette nach dem Amplitudenmodulator nicht mehr auftreten. Das dem Amplitudenmodulator zugeführte Eingangssignal kann optional Gleichspannungsanteile enthalten, welche durch den Amplitudenmodulator mit Trägerunterdrückung in einen hochfrequenten Träger umgeformt werden. Ferner kann, wie dies nachfolgend beschrieben werden wird, der Signalpfad durch den Einsatz weiterer Komponenten gleichspannungsfrei gemacht werden. Die Signalverarbeitung bei der Wandlung des analogen Eingangssignals in das digitale Ausgangssignal erfolgt ohne Rückkopplung. Dies hat zur Folge, dass die Komponenten, die das analoge Eingangssignal verarbeiten, bezüglich der erreichbaren Grenzfrequenz nicht mehr den Flaschenhals darstellen. Insbesondere sind hierdurch auch saubere Sprungantworten möglich, eine Begrenzung erfolgt nur noch durch die gewählte Abtastrate. Hierdurch ist es möglich, einen A/D-Wandler für Frequenzen im GHz-Bereich aufzubauen.

Ein Rauschen kann nur in der Form von Phasenrauschen des Trägers auftreten. Da eine rauschbehaftete Oszillatorfrequenz zur Modulation wie auch zur Demodulation verwendet wird, werden diese Rauschanteile kompensiert. Durch Übertragungswege, deren Frequenzen durch Filter begrenzt sind, und einer endlichen Abtastfrequenz ist davon auszugehen, dass ein gewisses Rauschen erhalten bleibt.

Eine zweckmäßige Ausgestaltung sieht vor, dass das phasenmodulierte Signal (PM-Signal) gebildet wird aus Amplitudenmodulation des Eingangssignales mit einem Träger. Dieser Träger wird im Modulator unterdrückt. Das trägerlose Zweiseitenbandsignal wird mit einem 90°-Träger addiert. Nach Begrenzung dieses Signales steht ein PM-Signal zur Verfügung. Unter einem 90°-Trägersignal ist ein Trägersignal zu verstehen, dessen Phase um 90° gegenüber dem Träger des AM-Signals gedreht ist. Das Zweiseitenband-Signal enthält Seitenbänder mit jeweils gleicher Information. Durch die Erzeugung eines amplitudenmodulierten Signals mit Trägerunterdrückung entfällt die aufwändige Kompensation des in der Amplitudenmodulation enthaltenen Trägers. Durch die Addition eines neuen Trägers, welcher um 90° gegenüber dem Träger, der zu dem AM-Signal gehört, gedreht wird, erhält man ein phasenmoduliertes Signal (PM-Signal) mit maximal +/- 90° Phasenhub.

Der Amplitudenmodulator kann beispielsweise ein Ringmodulator, als transformatorloser Doppelgegentaktmodulator oder als Schaltermodulator ausgebildet sein. Insbesondere kommt als Schaltermodulator der bekannte Doppelgegentaktmodulator (übertragerlos im Signalpfad) in Frage.

Eine weitere zweckmäßige Ausgestaltung sieht vor, dass die Vorrichtung ein erstes Filterelement umfasst, welches aus einem ihr zugeführten ersten digitalen Trägersignal ein sinusförmiges Trägersignal erzeugt, das dem Amplitudenmodulator zugeführt und durch den Amplitudenmodulator mit dem analogen Eingangssignal multipliziert wird. Das erste digitale Trägersignal wird aus einer Takterzeugung generiert. Zur Takterzeugung und Phasendemodulation wird digitale Schaltungstechnik eingesetzt.

Zusätzlich umfasst die Vorrichtung ein zweites Filterelement, welches aus einem ihr zugeführten zweiten, digitalen Trägersignal ein sinusförmiges Trägersignal erzeugt, das um 90° zu dem ersten sinusförmigen Trägersignal verschoben ist und dem Addierer zugeführt wird, um durch den Addierer als Additionssignal zu dem AM-Signal addiert zu werden. Auch das zweite digitale Trägersignal wird aus dem ersten Trägersignal durch einen digitalen Schaltungsteil erzeugt. Das erste und das zweite digitale Trägersignal sind Rechtecksignale, welche um 90° zueinander phasenverschoben sind.

Das erste, digitale Trägersignal und/oder das zweite, digitale Trägersignal werden insbesondere aus einem Muttergenerator erzeugt, so dass diese gegeneinander phasenstarr sind.

Das erste und/oder das zweite Filterelement können als Tiefpass oder als Bandpass ausgebildet sein. Insbesondere kann als Bandpass ein Wien-Glied, umfassend zwei Kondensatoren und zwei Widerstände, genutzt werden.

Es ist weiterhin zweckmäßig, wenn zwischen dem Amplitudenmodulator und dem Addierer ein Kondensator angeordnet ist. Der Kondensator dient zur galvanischen Trennung und zur Abtrennung eines eventuell in dem analogen Eingangssignal enthaltenen Gleichspannungsanteils.

Eine weitere zweckmäßige Ausgestaltung sieht vor, dass zwischen dem Addierer und dem Begrenzer ein Kondensator angeordnet ist. Auch durch diesen Kondensator wird eine galvanische Trennung zwischen Eingangs- und Ausgangsteil ermöglicht. Es kann vorgesehen sein, den Kondensator sowohl zwischen dem Amplitudenmodulator und dem Addierer als auch zwischen dem Addierer und dem Begrenzer vorzusehen. Alternativ kann auch nur einer der beiden Kondensatoren vorgesehen sein.

Eine weitere zweckmäßige Ausgestaltung sieht vor, dass die Vorrichtung mehrere Eingangskanäle umfasst und pro Eingangskanal die oben beschriebenen Elemente vorgesehen sind. Dabei ist es jedoch nicht erforderlich, das erste und das zweite digitale Trägersignal für jeden Eingangskanal separat zu erzeugen. Vielmehr kann eine gemeinsame Einrichtung zur Erzeugung des ersten und/oder zweiten digitalen Trägersignals in dem digitalen Schaltungsteil genutzt werden.

Beim Vorsehen mehrerer Eingangskanäle ist eine galvanische Trennung durch das Vorsehen des oder der oben beschriebenen Kondensatoren sichergestellt.

Eine weitere zweckmäßige Ausgestaltung sieht vor, dass dem Signaleingang des Amplitudenmodulators ein Integrierer vorgeschaltet ist, welcher das analoge Eingangssignal verarbeitet bevor dieses dem Signaleingang zugeführt wird. Durch das Vorschalten des Integrierers (Integrierglied) am Eingang des Amplitudenmodulators wird der Phasenmodulator zum Frequenzmodulator.

Das vorstehend beschriebene Prinzip zur A/D-Wandlung ergänzt die bislang bekannten A/D-Wandlungen. Dabei ergeben sich verschiedene Vorteile gegenüber den bekannten Verfahren. Es gibt keine systembedingten Bandbreiten-Begrenzungen, d.h. ein Betrieb von 0 Hz (d.h. das analoge Eingangssignal ist ein Gleichspannungssignal) bis in den GHz-Bereich ist möglich. Genauigkeitsprobleme werden verringert, da keine Referenzspannung erforderlich ist. Darüber hinaus kann die Vorrichtung mit geringem Phasenrauschen realisiert sein, sofern sichergestellt ist, dass der Takt des ersten und/oder zweiten digitalen Trägersignals stabil ist, d.h. eine gemeinsame Referenzfrequenzquelle für Modulation/Demodulation vorgesehen ist.

Die Vorrichtung lässt sich auf einfache Weise zusammen integrieren, da bis auf den Addierer reine Digitalschaltungstechnik verwendbar ist. Dies gilt insbesondere, wenn der Amplitudenmodulator als Schaltmodulator realisiert wird.

Durch das Vorsehen eines oder mehrerer Kondensatoren ist auf einfache Weise eine Potentialtrennung zwischen Signaleingang und Signalausgang möglich. Dies gilt auch für solche analoge Eingangssignale, welche ein Gleichspannungssignal sind. In entsprechender Weise kann durch das Vorsehen mehrerer Kondensatoren eine einfache Potentialtrennung für mehrere Kanäle realisiert werden.

Hierdurch bedingt kann die Vorrichtung kostengünstig hergestellt werden. Die Vorrichtung ist sowohl für den Einsatz in Messtechnik als auch in ASICs, FPGAs oder DSPs denkbar.

Die Erfindung wird nachfolgend näher anhand von Ausführungsbeispielen in der Zeichnung erläutert. Es zeigen:

FIG 1 ein elektrisches Ersatzschaltbild eines ersten Ausführungsbeispiels der erfindungsgemäßen Vorrichtung mit einem einzigen Signaleingang;

FIG 2 ein elektrisches Ersatzschaltbild gemäß einem zweiten Ausführungsbeispiel einer erfindungsgemäßen Vorrichtung, welche beispielhaft zwei Eingangskanäle umfasst;

FIG 3      eine schematische Darstellung eines beispielhaft nutzbaren Filterelements in den Vorrichtungen gemäß FIG 1 und FIG 2;

FIG 4      ein Zeigerdiagramm, das die Wandlung eines PM-Signals aus einem AM-Signal zeigt, wobei ein Fall ohne Trägerunterdrückung gezeigt ist, mit der nicht praktikablen Erzeugung eines Korrektursignales (Vektor);

FIG 5      ein Spannungs-Zeit-Diagramm, das ein begrenztes PM-Signal im Vergleich zu einem Trägersignal zeigt;

FIG 6      ein Zeigerdiagramm, das den erfindungsgemäßen Umwandlungsprozess eines AM-Signals in ein PM-Signal illustriert; und

FIG 7 und 8      ein Zeigerdiagramm, das den Phasenhub bei Modulation durch ein symmetrisches harmonisches Signal und daraus ergebender nacheilender und vorauseilender Phase zeigt.

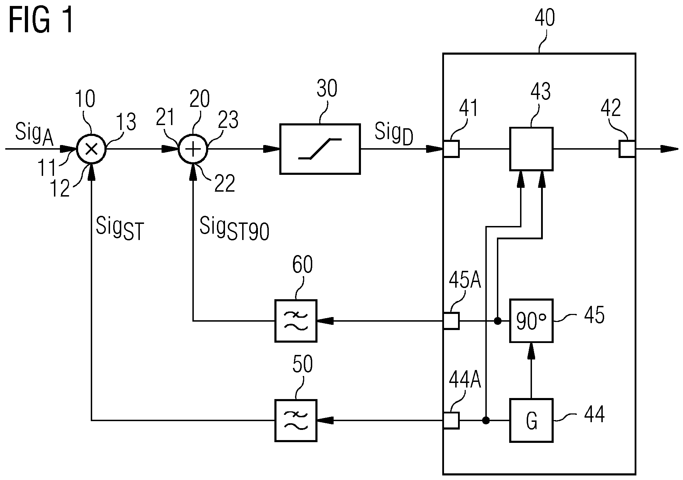

FIG 1 zeigt eine schematische Darstellung einer erfindungsgemäßen Vorrichtung zur Wandlung eines analogen Eingangssignals $Sig_A$ in ein digitales Ausgangssignal $Sig_D$. Die Vorrichtung, auch als A/D-Wandler bezeichnet, umfasst einen Amplitudenmodulator 10 mit Trägerunterdrückung, einen Addierer 20, einen Begrenzer 30, einen digitalen Schaltungsteil 40 sowie ein erstes und ein zweites Filterelement 50, 60.

Das analoge Eingangssignal $Sig_A$ wird dem Amplitudenmodulator 10 mit Trägerunterdrückung an einem Signaleingang 11 zugeführt. An einem Eingang 12 wird dem Amplitudenmodulator 10 ferner ein sinusförmiges Trägersignal $Sig_{ST}$ zugeführt. An einem Ausgang 13 des Amplitudenmodulators 10 wird ein trägerloses amplitudenmoduliertes Signal (AM-Signal) ausgegeben und dem Addierer 20 an einem Eingang 21 zugeführt. An einem weiteren Eingang 22 wird dem Addierer ein sinusförmiges Trägersignal $Sig_{ST90}$ zugeführt, das um 90° zu dem sinusförmigen Trägersignal $Sig_{ST}$ phasenverschoben ist. Durch Addition des trägerlosen AM-Signals und des sinusförmigen Trägersignals $Sig_{ST90}$, welches ein Additionssignal in Gestalt eines Zweiseitenband-Signals und des 90°-Trägersignals umfasst, wird ein phasenmoduliertes Signal (PM-Signal) mit Störamplitudenmodulation bereitgestellt. Dieses PM-Signal mit Störamplitude wird an einem Ausgang 23 des Addierers 20 ausgegeben und dem Begrenzer 30 zugeführt, der dazu ausgebildet ist, die darin enthaltene Störamplitudenmodulation in dem PM-Signal zu unterdrücken. Das somit entstandene digitale Ausgangssignal $Sig_D$ wird einem Eingang 41 des digitalen Schaltungsteiles 40 zugeführt, welcher dieses mit Hilfe eines digitalen Demodulators 43 demoduliert und an einem Ausgang 42 zur weiteren Verarbeitung bereitstellt.

Der digitale Schaltungsteil 40 umfasst eine erste Einheit 44 (Generator G) zur Erzeugung eines, digitalen Trägersignals, das als Rechtecksignal an einem Ausgang 44A bereitgestellt wird. Das Rechtecksignal wird dem ersten Filterelement 50, z.B. einem Tiefpass, zugeführt, welcher die erste Harmonische (Grundwelle) ausfiltert und das hieraus entstehende sinusförmige Signal als das sinusförmige Trägersignal $Sig_{ST}$ dem Amplitudenmodulator 10 zur Verarbeitung zuführt.

Der digitale Schaltungsteil 40 umfasst darüber hinaus eine zweite Einheit 45 zur Erzeugung eines zweiten, digitalen Trägersignals, wobei das zweite, digitale Trägersignal phasenstarr aus dem ersten, digitalen Trägersignal mit Hilfe eines Muttergenerators erzeugt ist. Das zweite, digitale Trägersignal ist ebenfalls ein Rechtecksignal, das um 90° phasenverschoben zu dem von der ersten Einheit 44 bereitgestellten Rechtecksignal ist. Dieses wird an einem Ausgang 45A des digitalen Schaltungsteiles dem zweiten Filterelement 60 zur Verfügung gestellt, welches ebenso die erste Harmonische (Grundwelle) aussiebt. Das somit entstehende sinusförmige Signal wird als das sinusförmige Trägersignal $Sig_{ST90}$ dem Eingang 22 des Addierers 20 zur Verfügung gestellt. Beide Rechtecksignale werden auch zur digitalen Demodulation verwendet. Das ganze System ist phasenstarr, damit wirken sich Änderungen in Phase und Frequenz auf alle Trägersignale aus.

Der Amplitudenmodulator 10 kann beispielsweise als Ringmodulator oder als Schaltermodulator (z.B. Doppelgegentaktmodulator) ausgebildet sein.

Aus dem analogen Eingangssignal $Sig_A$ wird durch den Amplitudenmodulator 10 mit Trägerunterdrückung und dem Addierer 20 ein phasenmoduliertes PM-Signal erzeugt, welches durch den Begrenzer 30 begrenzt wird, wodurch das digitale Ausgangssignal $Sig_D$ eine Amplitude aufweist, welche aus 0 oder 1 besteht. Die Länge dieser Impulse ist, in Abhängigkeit der gewählten Trägerfrequenz, welche von der ersten und zweiten Einheit 44, 45 erzeugt wird, wertkontinuierlich.

Für die nachfolgende Erklärung des Prinzips des verwendeten Phasenwandlers werden harmonische Signale verwendet, da mit den Winkel-Beziehungen auf einfache Weise gerechnet werden kann. Für das analoge Eingangssignal $Sig_A$, welches gewandelt werden soll, gilt dies nicht uneingeschränkt, da praktisch jede Signalform, einschließlich von Gleichsignalwerten, auftreten kann.

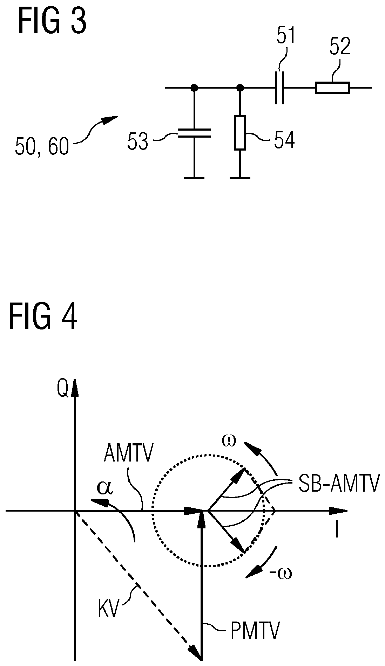

FIG 4 zeigt in einem Zeigerdiagramm die Wandlung eines phasenmodulierten PM-Signals aus einem amplitudenmodulierten AM-Signal. Das Zeigerdiagramm zeigt auf der horizontalen Achse und mit I gekennzeichnet die 0°-Phase und auf der vertikalen Achse und mit Q gekennzeichnet den 90°-Phasenträger (Quadratur-Achse). Mit AMTV ist der Vektor des AM-Trägers gekennzeichnet. SB-AMTV kennzeichnet die Vektoren der Seitenbänder des AM-Trägers, die in entgegengesetzter Richtung um die Pfeilspitze des AM-Trägers AMTV rotieren. Durch die Addition der beiden Vektoren SB-AMTV ergibt sich ein auf der I-Achse liegender Vektor veränderlicher Länge, der die Vektorlänge des AM-Trägers AMTV beeinflusst. Die Länge des Vektors AMTV liegt somit, ausgehend vom Ursprung des Zeigerdiagramms zwischen den Schnittpunkten des gestrichelt eingezeichneten Kreises und der I-Achse (Amplitudenmodulation). Parallel zur Q-Achse verläuft der Vektor des erzeugten PM-Trägersignals PMTV (erzeugt aus AMTV und KV), wobei dessen Pfeilspitze immer am Schnittpunkt des Ursprungs der Seitenbänder SB-AMTV liegt. Gestrichelt eingezeichnet ist ferner der notwendige Korrekturvektor für den PM-Träger PMTV, der ohne Trägerunterdrückung erzeugt werden müsste, was in der Praxis jedoch nahezu unmöglich ist.

Wird, wie mit Hilfe der erfindungsgemäßen Vorrichtung, ein amplitudenmoduliertes Signal mit Trägerunterdrückung gemäß Gleichung (2) erzeugt, entfällt die aufwändige Kompensation des Trägers des AM-Signals. Durch Addition eines neuen Trägers, welcher um 90° gegenüber dem Träger des AM-Signals gedreht wird, wird das erwünschte phasenmodulierte PM-Signal mit maximal +/- 90° Phasenhub erhalten. Dies wird durch Gleichung (3) ausgedrückt:

$$\sin(\alpha t) \cdot \cos(\omega t) = \frac{1}{2}[\sin((\alpha + \omega)t) + \sin((\alpha - \omega)t)] \qquad (2),$$

$$Upm(t) = \cos(\alpha t) + \sin((\alpha + \omega)t) + \sin((\alpha - \omega)t) \qquad (3)$$

wobei $\sin(\alpha t)$ der Träger, $\cos(\omega t)$ das Signal, $\cos(\alpha t)$ der 90°-Träger und $Upm(t)$ das phasenmodulierte Signal sind.

Reste der Amplitudenmodulation, welche eine Störmodulation darstellen, werden durch den Begrenzer 30 unterdrückt. Das digitale Ausgangssignal $Sig_D$ trägt die Modulation jetzt in zeitlich unterschiedlichen Nulldurchgängen im Vergleich zu dem 90°-Trägersignal ($Sig_{ST90}$) bzw. dem unterdrücktem AM-Träger ($Sig_{St}$). Die Amplitude schwankt zwischen 0 und 1, d.h. man erhält ein in der Amplitude digitales Signal.

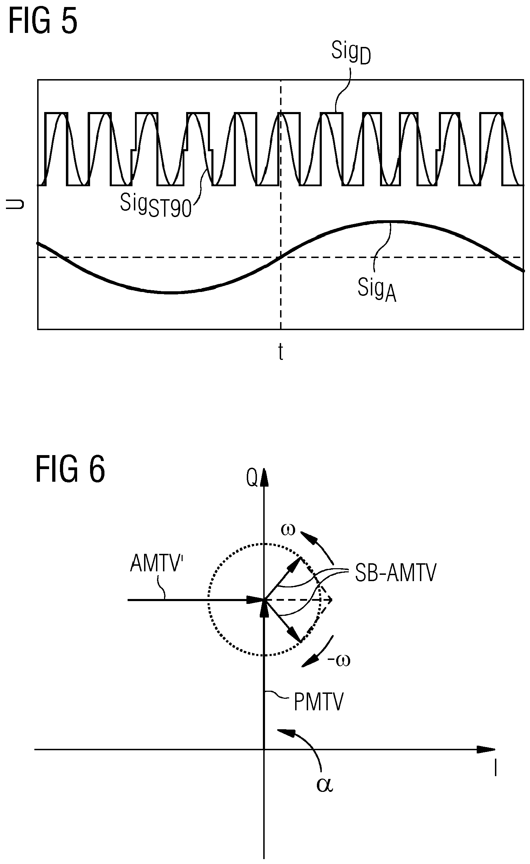

FIG 5 zeigt das begrenzte phasenmodulierte Signal $Sig_D$ im Vergleich zum 90°-Träger $Sig_{ST90}$ und das analoge Eingangssignal $Sig_A$ in einem Spannungs-Zeit-Diagramm. Die Abtastung des phasenmodulierten Signales 43 im digitalen Schaltungsteil 40 muss ausreichend schnell erfolgen, um Nulldurchgänge zu erfassen (Abtasttheorem). Die Information steckt nunmehr somit in der Länge der Rechteckpulse des digitalen Ausgangssignals $Sig_D$.

FIG 6 zeigt den Umwandlungsprozess im I-Q-Zeigerdiagramm. Dargestellt sind der Vektor des PM-Trägers PMTV, die Vektoren der Seitenbänder des AM-Trägers SB-AMTV und der Vektor AMTV' des unterdrückten AM-Trägers. Wie unschwer zu erkennen ist, liegt der Vektor des PM-Trägers PMTV nunmehr in der Q-Achse, während der Vektor des unterdrückten AM-Trägers AMTV' parallel zur I-Achse verläuft. Der unterdrückte Träger ist in der Praxis nicht existent.

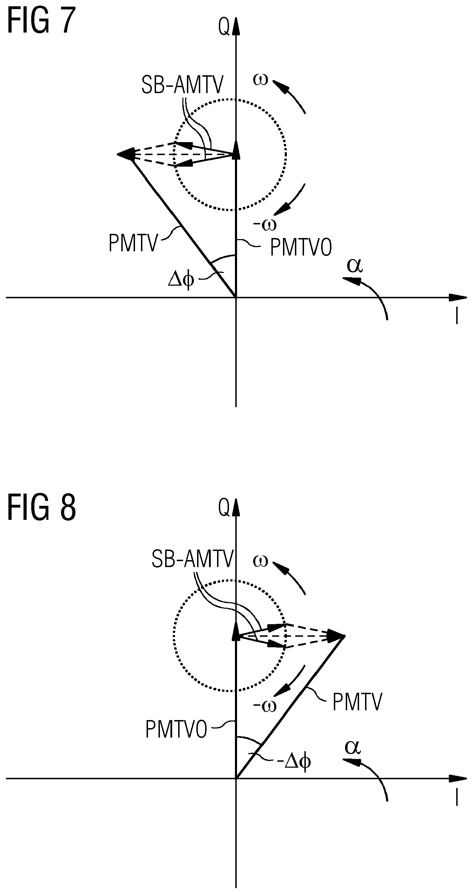

Die Figuren 7 und 8 zeigen jeweils eine Darstellung des Phasenhubs bei Modulation durch ein symmetrisches harmonisches Signal, wobei in FIG 7 der Vektor PMTV der Nulllage PMTV0 vorrauseilt und in FIG 8 der Vektor PMTV der Nulllage PMTV nacheilt. Bei der Modulation mit einem gleichspannungsfreien harmonischen Signal ergibt sich ein symmetrischer Phasenhub um die Trägerphasenlage. Bei maximaler Aussteuerung, d.h. einer Signalamplitude gegen unendlich, wird ein Phasenhub von +/- 90° erreicht.

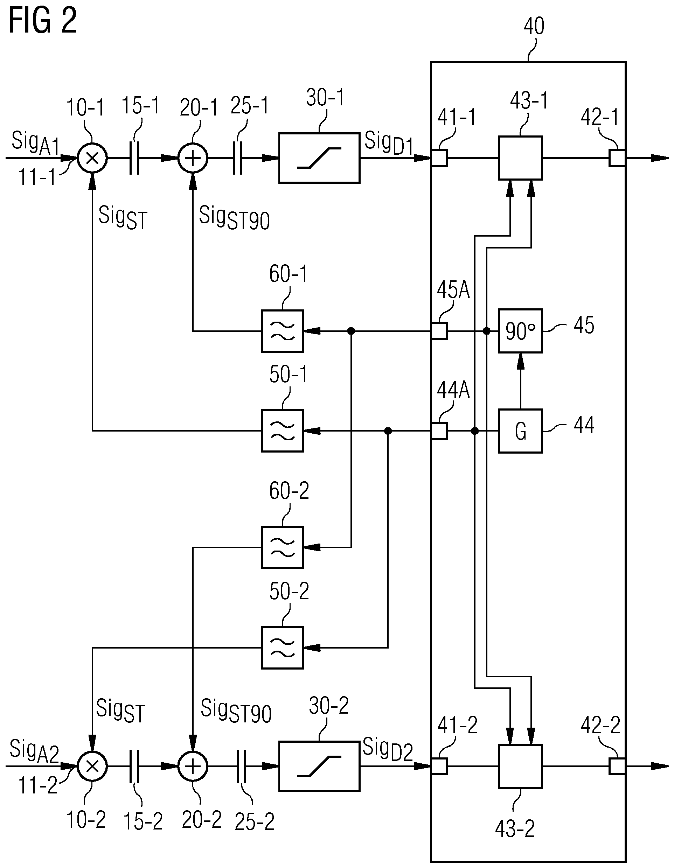

FIG 2 zeigt in einem zweiten Ausführungsbeispiel einen Mehrkanal-A/D-Wandler, der lediglich beispielhaft zwei Eingangskanäle umfasst. Die in FIG 2 enthaltenen Elemente entsprechen denen des in FIG 1 beschriebenen Wandlers, wobei Komponenten des ersten Eingangskanals mit dem Suffix "-1" und Elemente des zweiten Eingangskanals mit dem Suffix "-2" bezeichnet sind. Es ist ohne Weiteres zu erkennen, dass die erste und zweite Einheit 44, 45 zur Erzeugung des ersten bzw. zweiten digitalen Trägersignals gemeinsam für alle Eingangskanäle genutzt werden kann. Jedem Amplitudenmodulator 10-1, 10-2 und jedem Addierer 20-1, 20-2 ist jedoch ein jeweiliges Filterelement 50-1, 60-1 bzw. 50-2, 60-2 zugeordnet.

Als weiterer Unterschied zu dem in FIG 1 gezeigten Ausführungsbeispiel weist jeder Eingangskanal 1 und 2 im Signalpfad Kondensatoren 15-1 und 25-1 bzw. 15-2 und 25-2 auf. Die Kondensatoren 15-1, 15-2 sind zwischen dem Amplitudenmodulator 10-1, 10-2 und dem Addierer 20-1, 20-2 angeordnet. Die Kondensatoren 25-1, 25-2 sind zwischen dem Addierer 20-1, 20-2 und dem Begrenzer 30-1 und 30-2 des jeweiligen Eingangskanals angeordnet. Die Kondensatoren 15-i (i = 1, 2) und 25-i (i = 1, 2) dienen zur galvanischen Trennung. Darüber hinaus kann ein eventuell in dem analogen Modulationssignal enthaltender Gleichspannungsanteil abgetrennt werden.

In einem Eingangskanal können wahlweise einer oder beide der Kondensatoren 15-i und/oder 25-i enthalten sein.

Während die Filterelemente 50, 60 in dem in FIG 1 gezeigten Ausführungsbeispiel als Tiefpässe ausgebildet waren, sind diese in dem in FIG 2 gezeigten Ausführungsbeispiel als Bandpass vorgesehen. Ein solcher Bandpass kann beispielsweise als, wie in FIG 3 gezeigtes, Wien-Glied ausgebildet sein, welches in einer dem Fachmann bekannten Weise aus zwei Kondensatoren 51, 53 und zwei Widerständen 52, 54 besteht. Wie ohne weiteres ersichtlich ist, sind ein Kondensator 51 und ein Widerstand 52 seriell und ein Kondensator 53 und ein Widerstand 54 parallel zueinander verschaltet. Hierdurch ergibt sich durch die Kombination eines Tiefpasses mit einem Hochpass die gewünschte Bandpasscharakteristik. Der Widerstand 52 wird dabei, abhängig ob es sich um das Filterelement 50 oder 60 handelt, mit dem Ausgang 45A bzw. 44A verbunden. Der Knotenpunkt zwischen den Kondensatoren 51, 53 ist, abhängig davon, ob es sich um das Filterelement 50-i oder 60-i handelt, mit dem Amplitudenmodulator 10-i oder dem Addierer 20-i verbunden.

Der in FIG 2 gezeigte digitale Schaltungsteil 40 weist beispielhaft einen jeweiligen Ausgang 42-1 und 42-2 für die Ausgabe von demodulierten digitalen Ausgangssignalen auf. Ebenso weist der digitale Schaltungsteil 40 beispielhaft für jeden Eingangskanal jeweilige Schaltungseinheiten 43-1, 43-2 (Demodulatoren) auf.

Die digitale Schaltung, welche als digitaler PM-Demodulator arbeitet, erzeugt aus einem Takt das Trägersignal sowohl das 90°- Trägersignal für die analoge Phasenmodulation als auch für die digitale Phasendemodulation.

**Patentansprüche**

1.  Vorrichtung zur Wandlung eines analogen Eingangssignals ($Sig_A$) in ein digitales Ausgangssignal ($Sig_D$), umfassend:

    - einen Amplitudenmodulator (10) mit Trägerunterdrückung zur Bereitstellung eines trägerlosen amplitudenmodulierten Signals (AM-Signal), dem das analoge Eingangssignal an einem Signaleingang (11) zugeführt wird;
    - einen Addierer (20), dem das von dem Amplitudenmodulator (10) ausgegebene trägerlose AM-Signal zugeführt wird und der dazu eingerichtet ist, zu dem AM-Signal ein um 90° verschobenes Trägersignal zu addieren und ein phasenmoduliertes Signal (PM-Signal) bereitzustellen;
    - einen Begrenzer (30), dem das von dem Addierer (20) ausgegebene PM-Signal zugeführt wird und der dazu ausgebildet ist, eine störende Amplitumodulation in dem PM-Signal zu unterdrücken.

2.  Vorrichtung nach Anspruch 1, **dadurch gekennzeichnet, dass** das phasenmodulierte Signal gebildet wird aus einem Zweiseitenband-Signal sowie einem 90°-Trägersignal.

3.  Vorrichtung nach Anspruch 1 oder 2, **dadurch gekennzeichnet, dass** der Amplitudenmodulator (10) als Ringmodulator, oder transformatorloser Doppelgegentaktmodulator oder als Schaltermodulator ausgebildet ist.

4.  Vorrichtung nach einem der vorhergehenden Ansprüche, **dadurch gekennzeichnet, dass** diese ein erstes Filterelement (50) umfasst, welches aus einem ihr zugeführten ersten, digitalen Trägersignal ein sinusförmiges Trägersignal ($Sig_{ST}$) erzeugt, das dem Amplitudenmodulator (10) zugeführt und durch den Amplitudenmodulator (10) mit dem analogen Eingangssignal ($Sig_A$) multipliziert wird.

5.  Vorrichtung nach einem der vorhergehenden Ansprüche, **dadurch gekennzeichnet, dass** diese ein zweites Filterelement (50) umfasst, welches aus einem ihr zugeführten zweiten, digitalen Trägersignal ein sinusförmiges Trägersignal ($Sig_{ST90}$) erzeugt, das um 90° zu dem ersten sinusförmigen Trägersignal ($Sig_{ST}$) verschoben ist und dem Addierer (20) zugeführt wird, um durch den Addierer (20) als Additionssignal zu dem AM-Signal addiert zu werden.

6.  Vorrichtung nach einem der 4 und/oder 5, **dadurch gekennzeichnet, dass** erste, digitale Trägersignal und/oder das zweite, digitale Trägersignal aus einem Muttergenerator erzeugt werden, so dass diese gegeneinander phasenstarr sind.

7.  Vorrichtung nach Anspruch 4, 5 oder 6, **dadurch gekennzeichnet, dass** das erste und/oder das zweite Filterelement (50, 60) als Tiefpass oder als Bandpass, insbesondere als Wien-Glied, ausgebildet sind.

8.  Vorrichtung nach einem der vorhergehenden Ansprüche, **dadurch gekennzeichnet, dass** zwischen dem Amplitudenmodulator (10) und dem Addierer (20) ein Kondensator (15) zur Potentialtrennung angeordnet ist.

9.  Vorrichtung nach einem der vorhergehenden Ansprüche, **dadurch gekennzeichnet, dass** zwischen dem Addierer (20) und dem Begrenzer (30) ein Kondensator (25) zur Potentialtrennung angeordnet ist.

10. Vorrichtung nach einem der vorhergehenden Ansprüche, **dadurch gekennzeichnet, dass** diese mehrere Eingangskanäle umfasst und pro Eingangskanal gemäß einem der vorhergehenden Ansprüche ausgebildet ist.

11. Vorrichtung nach einem der vorhergehenden Ansprüche, **dadurch gekennzeichnet, dass** dem Signaleingang (11) des Amplitudenmodulators (10) ein Integrierer vorgeschaltet ist, welcher das analoge Eingangssignal (Sig$_A$) verarbeitet bevor dieses dem Signaleingang (11) zugeführt wird.

FIG 1

FIG 2

## FIG 3

51

52

50, 60

53

54

## FIG 4

Q

AMTV

α

ω

SB-AMTV

I

-ω

KV

PMTV

# FIG 5

# FIG 6

FIG 7

FIG 8

Europäisches
Patentamt

European
Patent Office

Office européen
des brevets

**EUROPÄISCHER RECHERCHENBERICHT**

Nummer der Anmeldung

EP 18 19 4798

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | RUTHROFF C L ET AL: "A linear phase modulator for large baseband bandwidths", BELL SYSTEM TECHNICAL JOURNAL, AT AND T, SHORT HILLS, NY, US, Bd. 49, Nr. 8, Oktober 1970 (1970-10), Seiten 1893-1903, XP011630200, ISSN: 0005-8580, DOI: 10.1002/J.1538-7305.1970.TB04293.X [gefunden am 2014-03-15] * Seite 1894, Absatz 2 * * Abbildung 1 * ----- | 1-9 | INV. H03C3/40 H03M1/64 |
| X | US 4 028 641 A (BODTMANN WILLIAM FRED ET AL) 7. Juni 1977 (1977-06-07) * Zusammenfassung * * Spalte 2, Zeilen 28-43 * * Abbildungen 1,2 * ----- | 1-10 | |
| X | BENOIT R VEILLETTE ET AL: "On-Chip Measurement of the Jitter Transfer Function of Charge-Pump Phase-Locked Loops", IEEE JOURNAL OF SOLID-STATE CIRCUITS, IEEE SERVICE CENTER, PISCATAWAY, NJ, USA, Bd. 33, Nr. 3, März 1998 (1998-03), XP011060698, ISSN: 0018-9200 * Abbildung 1 * ----- -/-- | 1-9 | RECHERCHIERTE SACHGEBIETE (IPC) H03M H03D H03C |

Der vorliegende Recherchenbericht wurde für alle Patentansprüche erstellt

| Recherchenort | Abschlußdatum der Recherche | Prüfer |
|---|---|---|
| Den Haag | 12. März 2019 | Rocha, Daniel |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument
...............................................................................................
& : Mitglied der gleichen Patentfamilie, übereinstimmendes
Dokument

EPO FORM 1503 03.82 (P04C03)

Seite 1 von 3

Europäisches
Patentamt

European
Patent Office

Office européen
des brevets

**EUROPÄISCHER RECHERCHENBERICHT**

Nummer der Anmeldung

EP 18 19 4798

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EILERS C G: "STEREOPHONIC FM BROADCASTING", IEEE TRANSACTIONS ON CONSUMER ELECTRONICS, IEEE SERVICE CENTER, NEW YORK, NY, US, Bd. CE-28, Nr. 1, Februar 1982 (1982-02), Seiten 5-12, XP000794626, ISSN: 0098-3063, DOI: 10.1109/TCE.1982.353864 * Seite 11, rechte Spalte - Seite 12, linke Spalte * * Abbildung 4 * ----- | 1-9 | |
| X | EILERS C G: "STEREOPHONIC FM BROADCASTING", IRE TRANSACTIONS ON BROADCAST AND TELEVISION RECEIVERS, IEEE INC. NEW YORK, US, Bd. BRT-07, Nr. 2, Juli 1961 (1961-07), Seiten 73-80, XP000794651, * Seite 79, rechte Spalte - Seite 80, linke Spalte * * Abbildung 4 * ----- | 1-9 | |
| X | PARSONS J D ET AL: "DATA TRANSMISSION OVER V.H.F. MOBILE-RADIO LINKS USING BINARY F.S.K. AND TWO QUASISYNCHRONOUS TRANSMITTERS", IEE PROCEEDINGS F. COMMUNICATIONS, RADAR & SIGNALPROCESSING, INSTITUTION OF ELECTRICAL ENGINEERS. STEVENAGE, GB, Bd. 127, Nr. 6, PART F, Dezember 1980 (1980-12), Seiten 456-463, XP000760491, ISSN: 0956-375X * Seite 456, rechte Spalte * * Abbildung 1 * ----- -/-- | 1-9,11 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| Den Haag | 12. März 2019 | Rocha, Daniel |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

Europäisches
Patentamt

European
Patent Office

Office européen
des brevets

# EUROPÄISCHER RECHERCHENBERICHT

**Nummer der Anmeldung**

EP 18 19 4798

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| T | EDWIN H ARMSTRONG: "A METHOD OF REDUCING DISTURBANCES IN RADIO SIGNALING BY A SYSTEM OF FREQUENCY MODULATION*", PROCEEDINGS OF THE INSTITUTE OF RADIO ENGINEERS, Bd. 24, Nr. 5, Mai 1936 (1936-05), Seiten 689-740, XP55567723, DOI: 10.1109/JRPROC.1936.227383 ----- | | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| Den Haag | 12. März 2019 | Rocha, Daniel |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
..................................................................................................
& : Mitglied der gleichen Patentfamilie, übereinstimmendes
    Dokument

EPO FORM 1503 03.82 (P04C03)

Seite 3 von 3

**ANHANG ZUM EUROPÄISCHEN RECHERCHENBERICHT
ÜBER DIE EUROPÄISCHE PATENTANMELDUNG NR.**

EP 18 19 4798

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-03-2019

| Im Recherchenbericht angeführtes Patentdokument | Datum der Veröffentlichung | Mitglied(er) der Patentfamilie | Datum der Veröffentlichung |
|---|---|---|---|
| US 4028641 A | 07-06-1977 | DE 2720649 A1 | 01-12-1977 |
| | | FR 2351537 A1 | 09-12-1977 |
| | | GB 1529163 A | 18-10-1978 |
| | | IT 1083354 B | 21-05-1985 |
| | | JP S6057723 B2 | 17-12-1985 |
| | | JP S52137243 A | 16-11-1977 |
| | | NL 7705009 A | 15-11-1977 |
| | | US 4028641 A | 07-06-1977 |

EPO FORM P0461

Für nähere Einzelheiten zu diesem Anhang : siehe Amtsblatt des Europäischen Patentamts, Nr.12/82